(19) Europäisches Patentamt
European Patent Office
Office européen des brevets

(11) **EP 3 126 293 B1**

(12) **FASCICULE DE BREVET EUROPEEN**

(45) Date de publication et mention de la délivrance du brevet:
**21.03.2018 Bulletin 2018/12**

(21) Numéro de dépôt: **15720356.3**

(22) Date de dépôt: **03.04.2015**

(51) Int Cl.:
*C01G 29/00* (2006.01)     *H01L 31/00* (2006.01)

(86) Numéro de dépôt international:
**PCT/EP2015/097024**

(87) Numéro de publication internationale:
**WO 2015/150592 (08.10.2015 Gazette 2015/40)**

(54) **OXYDES ET SULFURES MIXTES DE BISMUTH ET ARGENT POUR APPLICATION PHOTOVOLTAIQUE**

MISCHOXIDE UND SULFIDE VON WISMUT UND SILBER ZUR PHOTOVOLTAISCHEN VERWENDUNG

MIXED OXIDES AND SULPHIDES OF BISMUTH AND SILVER FOR PHOTOVOLTAIC USE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.04.2014 FR 1400833**

(43) Date de publication de la demande:
**08.02.2017 Bulletin 2017/06**

(73) Titulaires:
• **Rhodia Operations**
**75009 Paris (FR)**
• **Le Centre National de la Recherche Scientifique**
**75794 Paris (FR)**

(72) Inventeurs:
• **LE MERCIER, Thierry**
**F-93110 Rosny sous Bois (FR)**
• **BARBOUX, Philippe**
**F-94240 L'Hay les Roses (FR)**
• **LE BAHERS, Tangui**
**F-69003 Lyon (FR)**

(74) Mandataire: **Delenne, Marc**
**Rhodia Services**
**Direction de la Propriété Industrielle**
**40, rue de la Haie-Coq**
**93306 Aubervilliers Cedex (FR)**

(56) Documents cités:
**WO-A1-2010/024500     WO-A2-2014/049172**

**Description**

La présente invention a trait au domaine des composés inorganiques semi-conducteurs, en particulier destinés à fournir un photocourant, notamment par effet photovoltaïques.

De nos jours, les technologies photovoltaïques employant des composés inorganiques sont principalement fondées sur les technologies du silicium (plus de 80% du marché) et sur les technologies dites « couche mince » (principalement le CdTe et le CIGS (Cuivre Indium Gallium Sélénium), représentant 20% du marché). La croissance du marché du photovoltaïque semble exponentielle (40 GW cumulés en 2010, 67 GW cumulés en 2011).

Malheureusement, ces technologies souffrent d'inconvénients limitant leur capacité à satisfaire ce marché grandissant. Ces inconvénients incluent une mauvaise flexibilité pour ce qui est du silicium d'un point de vue mécanique et d'installation, et la toxicité et la rareté des éléments pour les technologies « couche mince ». En particulier, le cadmium, le tellure et le sélénium sont toxiques. Par ailleurs, l'indium et le tellure sont rares, ce qui se répercute notamment sur leur coût.

Pour ces raisons, on cherche à s'affranchir de la mise en oeuvre de l'indium, du cadmium, du tellure et du sélénium ou à diminuer leur proportion.

Une voie qui a été préconisée pour remplacer l'indium dans le CIGS est de le remplacer par le couple ($Zn^{2+}$, $Sn^{4+}$). Dans ce cadre, il a été notamment proposé le composé $Cu_2ZnSnSe_4$ (dit CZTS). Ce matériau est aujourd'hui considéré comme le plus sérieux successeur du CIGS en termes d'efficacité, mais qui présente l'inconvénient de toxicité du sélénium.

Pour ce qui est du sélénium et du tellure, peu de solutions de substitution ont été proposées et elles s'avèrent généralement peu intéressantes. Les composés comme le SnS, le $FeS_2$ et le $Cu_2S$ ont bien été testés mais, bien qu'ils aient des propriétés intrinsèques intéressantes (gap, conductivité...), ils ne s'avèrent pas assez stables chimiquement (ex : le $Cu_2S$ se transforme très facilement en $Cu_2O$ au contact de l'air et de l'humidité). WO 2014/049172 A2 divulgue des oxydes et sulfures mixtes de bismuth et cuivre pour application photovoltaïque.

WO 2010/024500 A1 divulgue un composé de formule $Bi_{1-x}M_xCu_wO_{a-y}Q1_yTe_{b-z}Q2_z$, où M est au moins un élément choisi du groupe comprenant Ba, Sr, Ca, Mg, Cs, K, Na, Cd, Hg, Sn, Pb, Eu, Sm, Mn, Ga, In, Tl, As et Sb; Q1 et Q2 sont au moins un élément choisi du groupe comprenant S, Se, As et Sb avec 0<=x<1, 0<w<=1, 0.2<a<4, 0<=y<4, 0.2<b<4 and 0<=z<4.

A ce jour, à la connaissance des inventeurs, il n'a pas été publié de solution satisfaisante permettant d'obtenir une bonne efficacité photovoltaïque sans problèmes liés à la toxicité et/ou la rareté des éléments employés dans un système photovoltaïque.

Un but de la présente invention est justement de fournir des composés inorganiques alternatifs à ceux utilisés dans les technologies photovoltaïques actuelles, qui permettent d'éviter les problèmes précités.

A cet effet, la présente invention propose d'utiliser une nouvelle famille de matériaux inorganiques, dont les inventeurs ont maintenant mis en évidence que, de façon inattendue, ils s'avèrent présenter une bonne efficacité, et qu'ils présentent l'avantage de ne pas avoir à utiliser, ou à une très faible teneur, des métaux rares ou toxiques du type In, Te, Cd précités, et offrent en outre la possibilité d'employer des anions, tels que Se ou Te, en une teneur réduite, voire de ne pas utiliser ce type d'anions.

L'un des objets de la présente invention est un nouveau matériau comprenant au moins un composé de formule (I) :

$$Bi_{1-x}M_xAg_{1-y-\varepsilon}M'_yOS_{1-z}M''_z \qquad (I)$$

dans lequel

M est un élément ou un mélange d'éléments choisis dans le groupe (A) constitué par Pb, Sn, Hg, Ca, Sr, Ba, Sb, In, Tl, Mg, les terres rares,
M' est un élément ou un mélange d'éléments choisis dans le groupe (B) constitué par Ti, V, Cr, Mn, Fe, Co, Ni, Cu, Zn, Ga, Al, Cd, Pt, Pd,
M" est un halogène,
x, y et z sont des nombres inférieurs à 1, en particulier inférieurs à 0,6, notamment inférieurs à 0,5, par exemple inférieurs à 0,2,

$$0 \le \varepsilon < 0,2.$$

Lorsqu'ils sont présents, les éléments M, M' et M" sont généralement des éléments de substitution occupant respectivement la place de l'élément Bi, de l'élément Ag et de l'élément S.

Par « matériau comprenant au moins un composé de formule (I) », on entend un solide, généralement sous forme divisée (poudre, dispersion) ou sous forme d'un revêtement ou d'une couche continue ou discontinue sur un support, et qui comprend, voire consiste en, un composé répondant à la formule (I).

Par « terre rare », on entend les éléments du groupe constitué par l'yttrium et le scandium et les éléments de la classification périodique de numéro atomique compris inclusivement entre 57 et 71.

Selon un premier mode de réalisation, les nombres x, y et z sont nuls (x = y = z = 0). Ainsi, le composé de formule (I) selon l'invention répond à la formule suivante : $BiAg_{1-\varepsilon}OS$.

Selon un second mode de réalisation de l'invention, au moins un des nombres x, y ou z est non nul.

Selon ce second mode de réalisation de l'invention, l'élément M peut de préférence être choisi parmi les éléments Sb, Pb, Ba et les terres rares. L'élément M peut par exemple être du lutécium.

L'élément M' peut de préférence être choisi parmi les éléments Cu, Zn, Mn. L'élément M' peut par exemple être l'élément Cu.

L'élément M" peut notamment être l'élément I.

Dans une première variante de ce second mode de réalisation de l'invention, le composé de formule (I) selon l'invention répond à la formule suivante : $Bi_{1-x}M_xAg_{1-\varepsilon}OS$ ($I_a$), où x ≠ 0, ε est un nombre nul ou non nul et M est un élément ou un mélange d'éléments choisis dans le groupe (A) constitué par Pb, Sn, Hg, Ca, Sr, Ba, Sb, In, Tl, Mg, les terres rares.

Selon un mode de réalisation de cette variante de l'invention, M est un élément ou un mélange d'éléments choisis parmi les terres rares.

Le composé peut alors par exemple répondre à la formule $Bi_{1-x}Lu_xAgOS$ où x ≠ 0 et ε = 0.

Dans une deuxième variante de l'invention, le composé de formule (I) selon l'invention répond à la formule suivante : $BiAg_{1-y-\varepsilon}M'_yOS$ ($I_b$), où y ≠ 0, ε est un nombre nul ou non nul et M' est un élément ou un mélange d'éléments choisis dans le groupe (B) constitué par Ti, V, Cr, Mn, Fe, Co, Ni, Cu, Zn, Ga, Al, Cd, Pt, Pd.

Selon un mode de réalisation de cette variante de l'invention, M' est un élément ou un mélange d'éléments choisis parmi les éléments Cu et Zn.

Le composé peut alors par exemple répondre à la formule $BiAg_{1-y}Cu_yOS$ ou à la formule $BiAg_{1-y}Zn_yOS$ où y ≠ 0 et ε = 0.

Dans une troisième variante de l'invention, le composé de formule (I) selon l'invention répond à la formule suivante : $BiAgOS_zM"_{1-z}$ ($I_c$), où z ≠ 0, ε est un nombre nul ou non nul et M" est un halogène.

Selon un mode de réalisation de cette variante de l'invention, M" est l'élément I, et le composé répond alors à la formule $BiAgOS_zI_{1-z}$ où z ≠ 0 et ε = 0.

L'invention a également pour objet un procédé de préparation du matériau selon l'invention comprenant une étape de broyage solide d'un mélange comprenant au moins des composés inorganiques de bismuth et d'argent, et éventuellement au moins un oxyde, sulfure, oxysulfure, halogénure ou oxyhalogénure d'au moins un élément choisi parmi Bi et les éléments du groupe (A) constitué par Pb, Sn, Hg, Ca, Sr, Ba, Sb, In, Tl, Mg, les terres rares, et éventuellement au moins un oxyde, sulfure, oxysulfure, halogénure ou oxyhalogénure d'au moins un élément choisi parmi Ag et les éléments du groupe (B) constitué par Ti, V, Cr, Mn, Fe, Co, Ni, Cu, Zn, Ga, Al, Cd, Pt, Pd.

Selon l'invention, on broie un mélange sous forme solide comprenant au moins des composés inorganiques de bismuth et d'argent. De préférence, les composés inorganiques de bismuth et d'argent présents dans le mélange sont au moins les composés $Bi_2O_3$, $Bi_2S_3$ et $Ag_2S$.

Ce broyage peut se faire selon tout moyen connu en soi. Ce mélange peut notamment être placé dans un mortier en agate. Le broyage peut par exemple être réalisé avec un broyeur planétaire.

Pour faciliter le broyage, il est possible d'ajouter au mélange sous forme solide des billes de broyage qui consistent par exemple en des billes en acier inoxydable, des billes en acier spécial au chrome, des billes en agate, des billes en carbure de tungstène, des billes en oxyde de zirconium.

Le temps de broyage peut être ajusté selon le produit recherché. Il peut notamment être compris entre 20 minutes et 96 heures, notamment entre 1 heure et 72 heures.

Les composés inorganiques de bismuth et d'argent dans le mélange peuvent se présenter sous la forme de particules présentant une granulométrie inférieure à 50 μm, en particulier inférieure à 10 μm, par exemple inférieure à 1 μm.

Les dimensions de particules auxquelles il est fait référence ici peuvent typiquement être mesurées par microscopie électronique à balayage (MEB).

La présente invention a en outre pour objet l'utilisation d'un matériau comprenant au moins d'un composé de formule (I) :

$$Bi_{1-x}M_xAg_{1-y-\varepsilon}M'_yOS_{1-z}M"_z \qquad (I)$$

dans lequel

M est un élément ou un mélange d'éléments choisis dans le groupe (A) constitué par Pb, Sn, Hg, Ca, Sr, Ba, Sb, In, Tl, Mg, les terres rares,

M' est un élément ou un mélange d'éléments choisis dans le groupe (B) constitué par Ti, V, Cr, Mn, Fe, Co, Ni, Cu, Zn, Ga, Al, Cd, Pt, Pd.

M" est un halogène,

x, y et z sont des nombres inférieurs à 1, en particulier inférieurs à 0,6, notamment inférieurs à 0,5, par exemple inférieurs à 0,2, et

$$0 \leq \varepsilon < 0,2$$

à titre de semi-conducteur, notamment pour application photoélectrochimique ou photochimique, en particulier pour fournir un photocourant.

Ce qui est indiqué dans l'exposé ci-dessus, notamment au sujet des éléments M, M' et M" et des nombres x, y et z s'applique à la présente utilisation selon l'invention.

Le composé qui est présent dans le matériau semi-conducteur est un matériau inorganique substitué, notamment du type p.

Les substitutions chimiques du bismuth, d'argent et/ou du soufre peuvent avoir plusieurs rôles.

Dans le cas de substitutions isoélectroniques telles que la substitution de l'élément Bi par des terres rares ou par l'élément Sb ou bien encore la substitution de l'élément Ag par l'élément Cu, ces substitutions peuvent, notamment en modifiant les paramètres de maille et/ou en modifiant l'extension des orbitales et leur position énergétique, ainsi entraîner des modifications du gap (bande de valence - bande de conduction).

Les substitutions aliovalentes modifient quant à elles le degré d'oxydation de l'élément Ag.

L'introduction de substituants dans la structure du semi-conducteur peut, selon le cas, entraîner une réduction ou une augmentation du nombre de porteurs de charges. Les matériaux substitués peuvent notamment présenter une conductivité plus élevée, qui induit une capacité de conduction améliorée, par rapport à sa forme non substituée, ou au contraire une conductivité plus faible.

Dans le cadre de la présente invention, les inventeurs ont maintenant mis en évidence que les matériaux répondant à la formule (I) précitée, en particulier, lorsqu'ils sont de type p, sont capables de fournir un photocourant lorsqu'ils sont irradiés sous une longueur d'onde supérieure à leur gap (à savoir la génération d'une paire électron-trou au sein du matériau sous l'effet d'un photon incident d'énergie suffisante, les espèces chargées formées (l'électron et le « trou », à savoir la lacune d'électron) étant libres de se déplacer pour engendrer un courant).

En particulier, les inventeurs ont maintenant mis en évidence que les matériaux de l'invention s'avèrent propres à assurer un effet photovoltaïque.

De façon générale, un effet photovoltaïque est obtenu par mise en oeuvre conjointe de deux composés semi-conducteurs de type distincts, à savoir :

- un premier composé présentant un caractère semi-conducteur de type p ; et
- un deuxième composé présentant un caractère semi-conducteur de type n.

Ces composés sont placés à proximité l'un de l'autre de façon connue en soi (à savoir en contact direct ou tout au moins à une distance suffisamment faible pour assurer l'effet photovoltaïques) pour former une jonction de type p-n. Les paires électron-trou créées par absorption de lumière sont dissociées au niveau de la jonction p-n et les électrons excités peuvent être véhiculés par le semi-conducteur de type n vers l'anode, les trous étant quant à eux conduits vers la cathode via le semi-conducteur de type p.

Dans le cadre de l'invention, l'effet photovoltaïque est typiquement obtenu en plaçant un matériau à base d'un semi-conducteur de formule (I) précitée, qui est en outre spécifiquement de type p, en contact avec un semi-conducteur de type n entre deux électrodes, en contact direct ou éventuellement connectés au moins à une des électrodes par l'intermédiaire d'un revêtement supplémentaire, par exemple un revêtement collecteur de charge ; et en irradiant le dispositif photovoltaïque ainsi réalisée par un rayonnement électromagnétique adéquat, typiquement par la lumière du spectre solaire. Pour ce faire, il est préférable qu'une des électrodes laisse passer le rayonnement électromagnétique employé.

Selon un autre aspect particulier, la présente invention a pour objet les dispositifs photovoltaïques comprenant, entre un matériau conducteur de trous et un matériau conducteur d'électrons, une couche à base d'un composé de formule (I) de type p et une couche à base d'un semi-conducteur de type n, où :

- la couche à base du composé de formule (I) est en contact avec la couche à base du semi-conducteur de type n ;

- la couche à base du composé de formule (I) est à proximité du matériau conducteur de trous ; et
- la couche à base du semi-conducteur de type n est à proximité du matériau conducteur d'électrons.

Par « matériau conducteur de trous » au sens de la présente description, on entend un matériau qui est capable d'assurer une circulation du courant entre le semi-conducteur de type p et le circuit électrique.

Le semi-conducteur de type n employé dans les dispositifs photovoltaïques selon l'invention peut être choisi parmi tout semi-conducteur qui présente un caractère accepteur d'électrons plus marqué que le composé de formule (I) ou un composé favorisant l'évacuation des électrons. De préférence, le semi-conducteur de type n peut être un oxyde, par exemple ZnO, ou TiO$_2$, ou un sulfure, par exemple ZnS.

Le matériau conducteur de trous employé dans les dispositifs photovoltaïques selon l'invention peut être par exemple un métal adapté, comme l'or, le tungstène, ou le molybdène ; ou un métal déposé sur un support, ou en contact avec un électrolyte, tel que Pt/FTO (platine déposé sur du dioxyde d'étain dopé au fluor) ; ou un oxyde conducteur comme de l'ITO (oxyde d'indium dopé étain), par exemple, déposé sur du verre ; ou un polymère conducteur de type p.

Selon un mode de réalisation particulier, le matériau conducteur de trous peut comprendre un matériau conducteur de trous du type précité et un médiateur rédox, par exemple un électrolyte contenant le couple I$_2$/I$^-$, dans quel cas, le matériau conducteur de trous est typiquement Pt/FTO.

Le matériau conducteur d'électrons peut être, par exemple FTO, ou AZO (oxyde de zinc dopé aluminium), ou un semi-conducteur de type n.

Dans un dispositif photovoltaïque selon l'invention, les trous générés à la jonction p-n sont extraits *via* le matériau conducteur de trous et les électrons sont extraits *via* le matériau conducteur d'électrons du type précités.

Dans un dispositif photovoltaïque selon l'invention, il est préférable que le matériau conducteur de trous et/ou le matériau conducteur d'électrons soit un matériau au moins partiellement transparent qui permet de laisser passer le rayonnement électromagnétique employé. Dans ce cas, le matériau au moins partiellement transparent est avantageusement placé entre la source du rayonnement électromagnétique incident et le semi-conducteur de type p.

A cet effet, le matériau conducteur de trous peut par exemple être un matériau choisi parmi un métal ou un verre conducteur.

Alternativement ou conjointement, le matériau conducteur d'électrons peut être au moins partiellement transparent, et on le choisit alors par exemple parmi FTO (dioxyde d'étain dopé au fluor), ou AZO (oxyde de zinc dopé aluminium), ou un semi-conducteur de type n.

Selon un autre mode de réalisation intéressant, la couche à base d'un semi-conducteur de type n qui est en contact avec la couche à base d'un composé de formule (I) de type p peut en outre être au moins partiellement transparente.

Par « matériau partiellement transparent », on entend ici un matériau qui laisse passer une partie au moins du rayonnement électromagnétique incident, utile pour fournir le photocourant, et qui peut être :

- un matériau qui n'absorbe pas totalement le champ électromagnétique incident ; et/ou
- un matériau qui est sous une forme ajourée (comportant typiquement des trous, des fentes ou des interstices) propre à laisser passer une partie du rayonnement électromagnétique sans que celui-ci rencontre le matériau.

Le composé de formule (I) employé selon la présente invention est avantageusement utilisé sous la forme d'objets isotropes ou anisotropes ayant au moins une dimension inférieure à 50 μm, de préférence inférieure à 20 μm, typiquement inférieure à 10 μm, préférentiellement inférieure à 5 μm, généralement inférieure à 1 μm, plus avantageusement inférieure à 500 nm, par exemple inférieure à 200 nm, voire à 100 nm.

Typiquement, la dimension inférieure à 50 μm peut être :

- le diamètre moyen dans le cas d'objets isotropes ;
- l'épaisseur ou le diamètre transversal dans le cas d'objets anisotropes.

Selon une première variante, les objets à base d'un composé de formule (I) sont des particules, ayant typiquement des dimensions inférieures à 10 μm.

Ces particules sont de préférence obtenues selon l'un des procédés de préparation de l'invention.

Par « particules », on entend ici des objets isotropes ou anisotropes, qui peuvent être des particules individuelles, ou bien des agrégats.

Les dimensions des particules auxquelles il est fait référence ici peuvent typiquement être mesurées par microscopie électronique à balayage (MEB).

Avantageusement, le composé de formule (I) est sous la forme de particules anisotropes de type plaquette, ou d'agglomérats de quelques dizaines à quelques centaines de particules de ce type, ces particules de type plaquette ayant typiquement des dimensions restant inférieures à 5 μm, (préférentiellement inférieures à 1 μm, plus avantageu-

sement inférieures à 500 nm), avec une épaisseur qui reste typiquement inférieure à 500 nm, par exemple inférieure à 100 nm.

Les particules du type décrit selon la première variante peuvent typiquement être employées à l'état déposé sur un support conducteur ou semi-conducteur de type n.

Une plaque d'ITO ou de métal recouverte de particules de formule (I) de type p selon l'invention peut ainsi, par exemple jouer le rôle d'une électrode photoactive pour un dispositif de type photoélectrochimique qui peut être utilisé notamment comme photodétecteur.

Typiquement, un dispositif de type photoélectrochimique mettant en oeuvre une électrode photoactive du type précité, comprend un électrolyte qui est généralement une solution de sel, par exemple, une solution de KCl, ayant typiquement une concentration de l'ordre de 1 M, dans lequel sont plongées :

- une électrode photoactive du type précité (plaque d'ITO ou métal recouverts de particules de composé de formule (I) selon l'invention) ;
- une électrode de référence ; et
- une contre-électrode ;

ces trois électrodes étant liées entre elles, typiquement par un potentiostat.

Selon un mode de réalisation possible, le dispositif électrochimique peut comprendre :

- à titre d'électrode photoactive : un support (tel qu'une plaque d'ITO) recouvert des particules de composé de formule (I);
- à titre d'électrode de référence : par exemple, une électrode Ag/AgCl ; et
- à titre de contre-électrode : par exemple, un fil de platine ;

ces trois électrodes étant liées entre elles, typiquement par un potentiostat.

Lorsqu'un dispositif électrochimique de ce type est placé sous une source lumineuse, sous l'effet d'irradiation, des paires électrons-trous se forment et sont dissociées.

Lorsque l'électrolyte est une solution aqueuse, ce qui est le plus souvent le cas, l'eau dans l'électrolyte est réduite à proximité de l'électrode photoactive par les électrons générés, produisant de l'hydrogène et des ions $OH^-$. Les ions $OH^-$ ainsi produits vont migrer vers la contre-électrode via l'électrolyte ; et les trous du composé de formule (I) vont être extraits via le conducteur du type ITO et vont entrer dans le circuit électrique externe. Finalement, l'oxydation des $OH^-$ se réalise à l'aide des trous à proximité de la contre-électrode en produisant de l'oxygène. La mise en mouvement de ces charges (trous et électrons), induite par l'absorption de la lumière du composé de formule (I), génère un photocourant.

Le dispositif peut notamment être utilisé comme photodétecteur, le photocourant n'étant généré que lorsque le dispositif est éclairé.

Une électrode photoactive telle que décrite ci-dessus peut notamment être réalisée en employant une suspension, comprenant les particules d'un composé de formule (I) du type précité dispersés dans un solvant, et en déposant cette suspension sur un support, par exemple une plaque de verre recouvert d'ITO ou une plaque de métal, par la voie humide ou toute méthode d'enduction, par exemple, par dépôt de gouttes (« drop-casting » en anglais), centrifugation (« spin-coating » en anglais), trempage (« dip-coating » en anglais), jet d'encre ou encore par sérigraphie. Pour plus de détail à ce sujet, on pourra se reporter à l'article : R. M. Pasquarelli, D. S. Ginley, R. O'Hayre, dans Chem. Soc. Rev., vol 40, pp. 5406-5441, 2011. De préférence, les particules à base d'un composé de formule (I) qui sont présentes dans la suspension ont un diamètre moyen tel que mesuré par granulométrie laser (par exemple, au moyen d'une granulométrie laser de type Malvern) qui est inférieur à 5 $\mu$m.

Selon un mode de réalisation préférentiel, les particules de composé de formule (I) peuvent être préalablement dispersées dans un solvant, par exemple, le terpineol ou l'éthanol.

La suspension contenant les particules de composé de formule (I) peut être déposée sur un support, par exemple une plaque recouverte d'oxyde conducteur.

Selon une deuxième variante de l'invention qui se révèle bien adaptée à la réalisation de dispositifs photovoltaïques, le composé de formule (I) est sous la forme d'une couche continue à base du composé de formule (I) dont l'épaisseur est inférieure à 50 $\mu$m, de préférence inférieure à 20 $\mu$m, plus avantageusement inférieure à 10 $\mu$m, par exemple inférieure à 5 $\mu$m et typiquement supérieure à 500 nm.

Par « couche continue », on entend ici un dépôt homogène réalisé sur un support et recouvrant ledit support, non obtenu par un simple dépôt d'une dispersion de particules sur le support.

La couche continue à base d'un composé de formule (I) de type p selon cette variante particulière de l'invention est typiquement placée à proximité d'une couche d'un semi-conducteur de type n, entre un matériau conducteur de trous et un matériau conducteur d'électrons, pour former un dispositif photovoltaïque destiné à fournir un effet photovoltaïque.

Un semi-conducteur de type n dans l'utilisation selon l'invention peut être un oxyde conducteur, par exemple ZnO, ou TiO$_2$, ou un sulfure, par exemple ZnS.

Par ailleurs, on entend par couche « à base du composé de formule (I) » une couche comprenant du composé de formule (I), de préférence à raison d'au moins 50% en masse, voire à raison d'au moins 75% en masse.

Selon un mode de réalisation, la couche continue selon la deuxième variante est essentiellement constituée par du composé de formule (I), et elle comprend typiquement au moins 95% en masse, voire au moins 98% en masse, plus préférentiellement au moins 99% en masse du composé de formule (I).

La couche continue à base d'un composé de formule (I) employé selon ce mode de réalisation peut prendre plusieurs formes.

La couche continue peut notamment comprendre une matrice polymère et, dispersées au sein de cette matrice, des particules à base d'un composé de formule (I), typiquement de dimensions inférieures à 10 µm, voire inférieure à 5 µm, notamment du type de celles employées dans le premier mode de l'invention.

Typiquement, la matrice polymère comprend un polymère conducteur de type p, qui peut notamment être choisi parmi les dérivés du polythiophène, plus particulièrement parmi les dérivés du poly(3,4-ethylènedioxythiophène):poly(styrènesulfonate) (PEDOT:PSS).

Les particules à base du composé de formule (I) présentes dans la matrice polymère ont de préférence, des dimensions inférieures à 5 µm, qui peuvent notamment être déterminées par MEB.

L'invention va maintenant être illustrée plus en détails, en référence aux exemples illustratifs donnés ci-après et aux Figures ci-annexées, sur lesquelles :

- la Figure 1 est une représentation schématique en coupe d'une cellule photoélectrochimique utilisée dans l'exemple 2 décrit ci-après ;
- la Figure 2 est une représentation schématique en coupe d'un dispositif photodétecteur ;
- la Figure 3 est une représentation schématique en coupe d'un dispositif photovoltaïque ;
- la Figure 4 est une représentation schématique en coupe d'un dispositif photovoltaïque selon l'invention, non exemplifié.

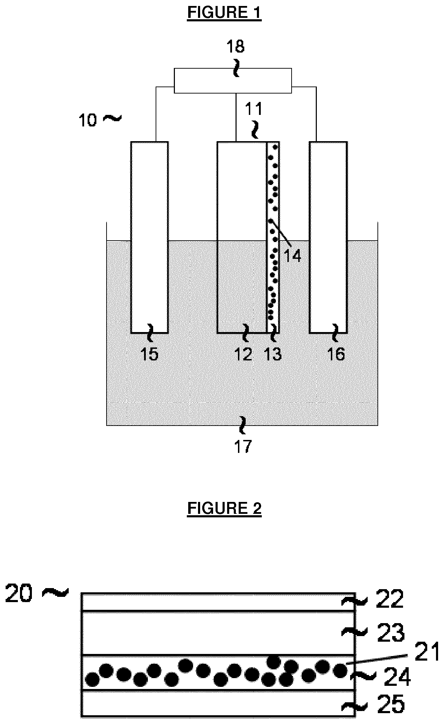

Sur la Figure 1 est représentée une cellule photoélectrochimique 10 qui comprend :

- une électrode photoactive 11 constituée par un support 12 à base d'un verre recouvert d'une couche conductrice d'ITO de 2 cm x 1 cm sur lequel a été déposé sur toute la surface une couche 13 d'épaisseur de l'ordre de 1 µm à base de particules 14 d'un composé de formule (I) selon l'invention, les particules 14 ont été préalablement dispersées dans du terpinéol puis déposées par enduction (« Doctor Blade Coating » en anglais) sur la plaque de verre conducteur 11.
- une électrode de référence (Ag/AgCl) 15 ; et
- une contre-électrode (fil de platine) 16 ;

Les trois électrodes 11, 15 et 16 sont plongées dans un électrolyte 17 de KCl à 1 M. Les trois électrodes sont reliées par un potentiostat 18.

Sur la Figure 2 est représenté un dispositif photodétecteur 20 qui comprend des particules 21 d'un composé de formule (I) selon l'invention. Ce dispositif comprend une couche 22 FTO d'épaisseur de l'ordre de 500 nm sur laquelle est électrodéposée une couche 23 d'épaisseur de l'ordre 1 µm à base de ZnO. La couche 24 d'épaisseur de l'ordre de 1 µm à base des particules 21 d'un composé de formule (I) selon l'invention est déposée à la surface de la couche 23 par dépôt des gouttes à partir d'une suspension de particules d'un composé de formule (I) selon l'invention à 25-30% en masse dans l'éthanol. Une couche d'or 25 d'épaisseur de l'ordre de 1 µm déposée sur la couche 24 par évaporation.

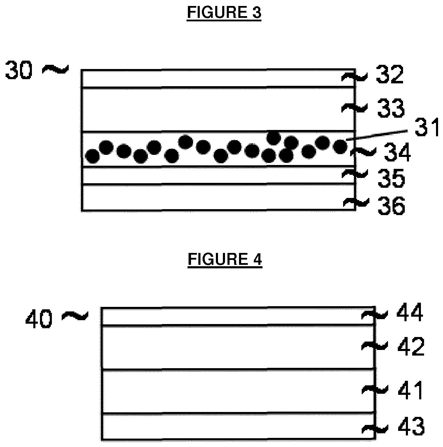

Sur la Figure 3 est représenté le dispositif photovoltaïque 30 qui comprend des particules 31 d'un composé de formule (I) selon l'invention. Ce dispositif comprend une couche 32 FTO d'épaisseur de l'ordre de 500 nm sur laquelle est électrodéposée une couche 33 d'épaisseur de l'ordre 1 µm à base de ZnO. La couche 34 d'épaisseur de l'ordre de 1 µm à base des particules 31 d'un composé de formule (I) selon l'invention est déposée à la surface de la couche 33 par dépôt des gouttes à partir d'une suspension de particules de formule (I) selon l'invention à 25-30% en masse dans l'éthanol. Un électrolyte contenant le couple de I$_2$/I$^-$ 35 servant de médiateur redox est déposé par dépôt des gouttes sur la surface de la couche 34, et sur lequel une couche d'or 36 d'épaisseur de l'ordre de 1 µm étant déposée par évaporation.

Sur la Figure 4 est représenté le dispositif photovoltaïque 40 qui comprend une couche 41 à base de particules d'un composé de formule (i) selon l'invention déposées sur une couche 42 à base de ZnO par enduction, la couche 42 à base de ZnO étant préparée par la dépôt sol-gel, la couche 41 étant en contact avec d'une couche 43 d'or et la couche 42 à base du ZnO étant en contact avec une couche FTO 44.

La mise en contact d'un composé de formule (I) selon l'invention avec un semi-conducteur de type n ZnO forme une jonction p-n. Lorsque le dispositif est placé sous une source lumineuse, les électrons générés vont dans le ZnO et les trous générés restent dans le composé de formule (I) selon l'invention. Le ZnO est en contact avec du FTO (conducteur des électrons) pour en extraire les électrons et le composé de formule (I) selon l'invention est en contact avec de l'or (conducteur des trous) pour en extraire les trous.

Les exemples suivants illustrent l'invention sans toutefois en limiter la portée.

## EXEMPLES

## EXEMPLE 1

## Procédé de préparation des particules BiAgOS

On a préparé une poudre de BiAgOS par broyage réactif à température ambiante, selon le protocole suivant :

0,685 g de $Bi_2S_3$, 1,243 g de $Bi_2O_3$ et 0,991 g de $Ag_2S$ sont placés dans un mortier en agate en présence de billes de broyage en agate.

Le mortier est alors couvert et placé dans un broyeur planétaire de type Fritsch N° 6 avec une vitesse de rotation de l'ordre de 500 tr/min. Le broyage se poursuit pendant 120 min jusqu'à l'obtention d'une phase pure.

Le composé obtenu $C_1$ caractérisé par diffraction des rayons X présente les paramètres de maille tétragonale suivants : a = 3,92 Å, c = 9,23 Å, V = 141,7 $Å^3$.

## EXEMPLE 2

## Utilisation du composé $C_1$ dans un dispositif photoélectrochimique

On a utilisé le dispositif décrit sur la Figure 1, en polarisant l'électrode de travail à un potentiel de -0,8 V vs Ag/AgCl. Le système est irradié sous une lampe à incandescence (dont la température de couleur est à 2700 K) alternant des périodes d'obscurité et des périodes lumineuses. L'intensité du courant a augmenté lorsque le système a été placé à la lumière. Il s'agit d'un photocourant mesuré à 100 $\mu$A.cm$^{-2}$, ce qui confirme l'aptitude du composé $C_1$ à générer un photocourant. Ce photocourant est cathodique (c'est-à-dire négatif) ce qui est en accord avec le fait que ce composé $C_1$ est un semi-conducteur de type p.

## Revendications

1. Matériau comprenant au moins un composé de formule (I) :

$$Bi_{1-x}M_xAg_{1-y-\varepsilon}M'_yOS_{1-z}M''_z \qquad (I)$$

dans lequel

M est un élément ou un mélange d'éléments choisis dans le groupe (A) constitué par Pb, Sn, Hg, Ca, Sr, Ba, Sb, In, Tl, Mg, les terres rares,
M' est un élément ou un mélange d'éléments choisis dans le groupe (B) constitué par Ti, V, Cr, Mn, Fe, Co, Ni, Cu, Zn, Ga, Al, Cd, Pt, Pd,
M'' est un halogène,
x, y et z sont des nombres inférieurs à 1, en particulier inférieurs à 0,6, notamment inférieurs à 0,5, et

$$0 \leq \varepsilon < 0,2.$$

2. Matériau selon la revendication 1, dans lequel les nombres x, y et z sont nuls, ce par quoi le composé de formule (I) répond à la formule suivante :

$$BiAg_{1-\varepsilon}OS$$

3. Matériau selon la revendication 1, dans lequel au moins un des nombres x, y ou z est non nul.

4. Procédé de préparation d'un matériau selon l'une des revendications 1 à 3, comprenant une étape de broyage solide d'un mélange comprenant au moins des composés inorganiques de bismuth et d'argent, et
éventuellement au moins un oxyde, sulfure, oxysulfure, halogénure ou oxyhalogènure d'au moins un élément choisi parmi Bi et les éléments du groupe (A), et,
éventuellement au moins un oxyde, sulfure, oxysulfure, halogénure ou oxyhalogénure d'au moins un élément choisi parmi Ag et les éléments du groupe (B).

5. Utilisation d'un matériau selon l'une des revendications 1 à 3 à titre de semi-conducteur, notamment pour application photoélectrochimique ou photochimique, en particulier pour fournir un photocourant.

6. Utilisation selon la revendication 5, où le composé de formule (I) est employé sous la forme d'objets isotropes ou anisotropes ayant au moins une dimension inférieure à 50 $\mu$m, de préférence inférieure à 20 $\mu$m.

7. Utilisation selon la revendication 6, où le composé de formule (I) est employé sous la forme de particules de dimensions inférieures à 10 $\mu$m.

8. Utilisation selon la revendication 7 où le composé de formule (I) est sous la forme de particules anisotropes de type plaquette, ou d'agglomérats de quelques dizaines à quelques centaines de particules de ce type.

9. Utilisation selon la revendication 6, où le composé de formule (I) est sous la forme d'une couche continue à base d'un composé de formule (I) dont l'épaisseur est inférieure à 50 $\mu$m, de préférence inférieure à 20 $\mu$m, où la couche à base d'un composé de formule (I) est une couche comprenant du composé de formule (I) à raison d'au moins du 95% en masse.

10. Utilisation selon la revendication 6, où le composé de formule (I) est sous la forme d'une couche continue à base d'un composé de formule (I) dont l'épaisseur est inférieure à 50 $\mu$m, de préférence inférieure à 20 $\mu$m, où la couche à base d'un composé de formule (I) comprend une matrice polymère et, dispersées au sein de cette matrice, des particules à base d'un composé de formule (I) de dimensions inférieures à 5 $\mu$m.

11. Dispositif photovoltaïque comprenant, entre un matériau conducteur de trous et un matériau conducteur d'électrons, une couche à base d'un composé de formule (I) selon l'une des revendications 1 à 3, de type p, et une couche à base d'un semi-conducteur de type n, où :

   - la couche à base du composé de formule (I) de type p est en contact avec la couche à base du semi-conducteur de type n ;
   - la couche à base du composé de formule (I) de type p est à proximité du matériau conducteur de trous ; et
   - la couche à base du semi-conducteur de type n est à proximité du matériau conducteur d'électrons.

**Patentansprüche**

1. Material, das mindestens eine Verbindung der Formel (I) umfasst:

$$Bi_{1-x}M_xAg_{1-y-\epsilon}M'_yOS_{1-z}M''_z \qquad (I)$$

worin

   M ein Element oder ein Gemisch von Elementen ist, aus der aus Pb, Sn, Hg, Ca, Sr, Ba, Sb, In, Tl, Mg, Seltenerden bestehenden Gruppe (A) ausgewählt ist,
   M' ein Element oder ein Gemisch von Elementen ist, das aus der aus Ti, V, Cr, Mn, Fe, Co, Ni, Cu, Zn, Ga, Al, Cd, Pt, Pd bestehenden Gruppe (B) ausgewählt ist,
   M" ein Halogen ist,
   x, y und z Zahlen kleiner als 1, insbesondere kleiner als 0,6, insbesondere kleiner als 0,5 sind und

$$0 \leq \epsilon < 0,2.$$

**2.** Material nach Anspruch 1, wobei die Zahlen x, y und z null sind, aus welchem Grund die Verbindung der Formel (I) der folgenden Formel entspricht:

$BiAg_{1-\epsilon}OS$

**3.** Material nach Anspruch 1, wobei mindestens eine der Zahlen x, y oder z nicht null ist.

**4.** Verfahren zur Herstellung eines Materials nach einem der Ansprüche 1 bis 3, das einen Schritt des Zerkleinerns im festen Zustand eines Gemischs umfasst, das mindestens anorganische Wismut- und Silberverbindungen und gegebenenfalls mindestens ein Oxid, Sulfid, Oxysulfid, Halogenid oder Oxyhalogenid mindestens eines aus Bi und den Elementen aus der Gruppe (A) ausgewählten Elements und gegebenenfalls mindestens ein Oxid, Sulfid, Oxysulfid, Halogenid oder Oxyhalogenid mindestens eines aus Ag und den Elementen aus der Gruppe (B) ausgewählten Elements umfasst.

**5.** Verwendung eines Materials nach einem der Ansprüche 1 bis 3 als Halbleiter, insbesondere zur photoelektrochemischen oder photochemischen Anwendung, insbesondere um einen Photostrom bereitzustellen.

**6.** Verwendung nach Anspruch 5, wobei die Verbindung der Formel (I) in Form isotroper oder anisotroper Objekte mit mindestens einer Abmessung kleiner als 50 $\mu$m, vorzugsweise kleiner als 20 $\mu$m, eingesetzt wird.

**7.** Verwendung nach Anspruch 6, wobei die Verbindung der Formel (I) in Form von Teilchen mit Abmessungen kleiner als 10 $\mu$m eingesetzt wird.

**8.** Verwendung nach Anspruch 7, wobei die Verbindung der Formel (I) in Form anisotroper Teilchen des Plättchentyps oder von Agglomeraten einiger zehn bis einiger hundert Teilchen dieses Typs vorliegt.

**9.** Verwendung nach Anspruch 6, wobei die Verbindung der Formel (I) in Form einer kontinuierlichen Schicht auf Basis einer Verbindung der Formel (I) vorliegt, deren Dicke kleiner als 50 $\mu$m, vorzugsweise kleiner als 20 $\mu$m ist, wobei die Schicht auf Basis einer Verbindung der Formel (I) eine Schicht ist, die die Verbindung der Formel (I) zu mindestens 95 Massen-% enthält.

**10.** Verwendung nach Anspruch 6, wobei die Verbindung der Formel (I) in Form einer kontinuierlichen Schicht auf Basis einer Verbindung der Formel (I) vorliegt, deren Dicke kleiner als 50 $\mu$m, vorzugsweise kleiner als 20 $\mu$m ist, wobei die Schicht auf Basis einer Verbindung der Formel (I) eine Polymermatrix und, innerhalb dieser Matrix dispergiert, Teilchen auf Basis der Verbindung der Formel (I) mit Abmessungen von kleiner als 5 $\mu$m umfasst.

**11.** Photovoltaikvorrichtung, die zwischen einem Lochtransportmaterial und einem Elektronentransportmaterial eine Schicht auf Basis einer Verbindung der Formel (I) nach einem der Ansprüche 1 bis 3 mit p-Dotierung und eine Schicht auf Basis eines Halbleiters mit n-Dotierung umfasst, wobei:

- die Schicht auf Basis der Verbindung der Formel (I) mit p-Dotierung in Kontakt mit der Schicht auf Basis des Halbleiters mit n-Dotierung steht;
- die Schicht auf Basis der Verbindung der Formel (I) mit p-Dotierung zu dem Lochtransportmaterial benachbart ist; und
- die Schicht auf Basis des Halbleiters mit n-Dotierung zu dem Elektronentransportmaterial benachbart ist.

**Claims**

**1.** Material comprising at least one compound of formula (I):

$$Bi_{1-x}M_xAg_{1-y-\epsilon}M'_yOS_{1-z}M''_z \qquad (I)$$

in which:

M is an element or a mixture of elements chosen from group (A) consisting of Pb, Sn, Hg, Ca, Sr, Ba, Sb, In, TI, Mg, rare earth metals,
M' is an element or a mixture of elements chosen from group (B) consisting of Ti, V, Cr, Mn, Fe, Co, Ni, Cu, Zn, Ga, Al, Cd, Pt, Pd,

M" is a halogen,

x, y and z are numbers less than 1, in particular less than 0.6, especially less than 0.5, and

$$0 \leq \varepsilon < 0.2.$$

2. Material according to Claim 1, wherein the numbers x, y and z are zero, whereby the compound of formula (I) corresponds to the following formula:

   $BiAg_{1-\varepsilon}OS$.

3. Material according to Claim 1, wherein at least one of the numbers x, y or z is not zero.

4. Process for preparing a material according to one of Claims 1 to 3, comprising a step of solid milling of a mixture comprising at least one of the inorganic compounds of bismuth and silver, and

   optionally at least one oxide, sulfide, oxysulfide, halide or oxyhalide of at least one element chosen from Bi and elements from group (A), and

   optionally at least one oxide, sulfide, oxysulfide, halide or oxyhalide of at least one element chosen from Ag and elements from group (B).

5. Use of a material according to one of Claims 1 to 3, as semiconductor, especially for photoelectrochemical or photochemical application, in particular for providing a photocurrent.

6. Use according to Claim 5, in which the compound of formula (I) is used in the form of isotropic or anisotropic objects having at least one dimension of less than 50 $\mu$m, preferably less than 20 $\mu$m.

7. Use according to Claim 6, in which the compound of formula (I) is used in the form of particles with dimensions of less than 10 $\mu$m.

8. Use according to Claim 7, in which the compound of formula (I) is in the form of anisotropic particles of platelet type, or of agglomerates of a few dozen to a few hundred particles of this type.

9. Use according to Claim 6, in which the compound of formula (I) is in the form of a continuous layer based on a compound of formula (I) whose thickness is less than 50 $\mu$m, preferably less than 20 $\mu$m, in which the layer based on a compound of formula (I) is a layer comprising the compound of formula (I) in a proportion of at least 95% by mass.

10. Use according to Claim 6, in which the compound of formula (I) is in the form of a continuous layer based on a compound of formula (I) whose thickness is less than 50 $\mu$m, preferably less than 20 $\mu$m, in which the layer based on a compound of formula (I) comprises a polymer matrix and, dispersed in this matrix, particles based on a compound of formula (I) with dimensions of less than 5 $\mu$m.

11. Photovoltaic device comprising, between a hole-conducting material and an electron-conducting material, a layer based on a p-type compound of formula (I) according to one of Claims 1 to 3, and a layer based on an n-type semiconductor, in which:

    - the layer based on the p-type compound of formula (I) is in contact with the layer based on the n-type semiconductor;
    - the layer based on the p-type compound of formula (I) is close to the hole-conducting material; and
    - the layer based on the n-type semiconductor is close to the electron-conducting material.

## FIGURE 1

## FIGURE 2

FIGURE 3

FIGURE 4

## RÉFÉRENCES CITÉES DANS LA DESCRIPTION

**Documents brevets cités dans la description**

- WO 2014049172 A2

- WO 2010024500 A1

**Littérature non-brevet citée dans la description**

- **R. M. PASQUARELLI ; D. S. GINLEY ; R. O'HAY-RE.** *Chem. Soc. Rev.,* 2011, vol. 40, 5406-5441